# EUROPEAN PATENT APPLICATION

(11) **EP 1 868 212 A1**
(43) Date of publication of application: **19.12.2007**
(21) Application number: 06715616.6
(22) Date of filing: 13.03.2006
(51) Int. Cl.: H01B 13/00

(54) **PROCESS FOR PRODUCING SUPERCONDUCTING WIRE ROD**

(30) Priority: 15.03.2005 JP 2005074021
(71) Applicant: Sumitomo Electric Industries, Ltd., Osaka-shi, Osaka 541-0041 (JP)
(72) Inventor: YAMAZAKI, Kouhei Sumitomo Electric Ind., Ltd., Osaka, 5540024 (JP); OSAMURA, Kozo c/o Kyoto University, Kyoto, 6068501 (JP); OGAWA, Teppei c/o Kyoto University, Kyoto, 6068501 (JP)
(74) Representative: Desormiere, Pierre-Louis
(86) International application number: PCT/JP2006/304893
(87) International publication number: WO 2006/098269

(57) **Abstract**

A method for producing a superconducting wire material having a high resistivity layer outside a superconducting material, which is capable of easily forming a homogeneous high resistivity layer, a superconducting wire material and a superconducting device are provided.

A raw material of superconducting wire material is coated with a first silver-containing metal to obtain a silver sheath member. This silver sheath member is coated with a non-silver metal free of silver. At least a part of the first silver-containing metal in the member coated with a non-silver metal and the non-silver metal are intermetallically compounded with each other. This intermetallically compounded metal is oxidized to form a high resistivity layer. The member having a high resistivity layer formed thereon is heat-treated to convert the aforementioned raw material to a superconducting material.

## Description

### TECHNICAL FIELD

The present invention relates to a method for producing a superconducting wire material, a superconducting wire material obtained by this method and a superconducting device comprising the superconducting wire material.

### BACKGROUND ART

As a superconducting wire material there is known a tape-like superconducting wire material having a plurality of Bi2223-based oxide superconducting material filaments embedded in a silver sheath. In order to suppress the rise of AC loss caused by the conduction between the filaments via the silver sheath in such a superconducting wire material during AC conduction, it has been practiced to form a high resistivity (insulating) layer outside the filaments so that the conduction between the filaments can be inhibited.

For example, Patent Reference 1 discloses a technique which comprises surrounding the periphery of a superconducting material by silver or the like, surrounding the periphery thereof by a metal, and then oxidizing the metal so that an insulating material made of a metal oxide is formed between silver and the metal.

Further, Patent Reference 2 discloses a technique which comprises surrounding a superconducting material by silver, surrounding the periphery thereof by a resistive alloy, and then oxidizing the resistive alloy so that an insulating oxide is formed between silver and the resistive alloy.

Further, Patent Reference 3 discloses a superconducting wire material obtained by coating a superconducting material of oxide with a sheath material made of a material containing silver, coating this sheath material with a high resistivity material, and then coating the high resistivity material with a coating material. This high resistivity material is formed by a ceramic powder of heat-resistant oxide. Further, the coating material is made of a material which is inactive to the high resistivity material in a high temperature oxidizing atmosphere.

Patent Reference 1: JP-T-11-501765
Patent Reference 2: JP-A-10-50152
Patent Reference 3: JP-A-11-312420

### DISCLOSURE OF THE INVENTION

### PROBLEMS TO BE SOLVED BY THE INVENTION

However, the aforementioned techniques have the following problems.
(1) It is difficult to form a homogeneous high resistivity layer.
When it is tried to directly oxidize a metal other than silver in contact with silver in an attempt to form a high resistivity layer made of an oxide, a silver alloy is somewhat produced at the interface of the metal with silver. At this point of time, the site in the metal apart from the interface with silver is oxidized to form an oxide, but it is likely that the interface with silver can be left unoxidized to remain as a silver alloy. Therefore, it is thought that the silver alloy is interposed between silver and the oxide, making it impossible to form a homogeneous high resistivity layer.

(2) There is a case where plasticizing during the production of a superconducting wire material cannot be easily effected.
A tape-like superconducting wire material is obtained by rolling or pressing a round wire material. For example, a powder of raw superconducting material is coated with silver the outer side of which is coated with Mg or the like, the material thus obtained is stretched, and the stretched wire material is then rolled to a tape form. In this case, silver is rich in ductility and malleability, but Mg is a difficultly workable material and is poor in workability particularly when rolled, that is, heavily deformed.

The present invention is worked out under the aforementioned circumstances and one of the objects thereof is to provide a method for producing a superconducting wire material having a high resistivity layer outside a superconducting material and capable of easily forming a homogeneous high resistivity layer.

Another object of the present invention is to provide a method for producing a superconducting wire material which can be easily subjected to plasticization such as rolling required at the procedure of producing a superconducting wire material.

Other object of the present invention is to provide a superconducting wire material obtained by the aforementioned method for producing a superconducting wire material and a superconducting device comprising the superconducting wire material.

### MEANS FOR SOLVING THE PROBLEMS

In the present invention, the aforementioned object is accomplished by intermetallically compounding a silver-containing metal with a non-silver metal other than silver during the formation of a high resistivity layer outside a superconducting material.

According to the present invention, there is provided a method for producing a superconducting wire material, including: a first coating step of coating a raw material of superconducting wire material with a first silver-containing metal to obtain a silver sheath member; a non-silver coating step of coating the silver sheath member with a non-silver metal free of silver; a compounding step of intermetallically compounding at least a part of the first silver-containing metal in the member which has passed through the non-silver coating step with the non-silver metal; an oxidizing step of oxidizing the intermetallically compounded metal to for a high resistivity layer; and a sintering step of heat-treating the member having a high resistivity layer formed thereon to convert the aforementioned raw material to a superconducting material.

By coating a silver sheath member with a non- silver metal, intermetallically compounding the silver in this silver sheath with the non-silver metal, and then effecting an oxidizing step after this intermetallic compound, the intermetallically compounded metal can be certainly converted to an oxide, making it possible to form a homogeneous high resistivity layer.

Further, even in the case where the non-silver metal is a difficultly workable material poor in ductility or malleability, the non-silver metal can be intermetallically compounded with a silver-containing metal rich in ductility or the like to improve its workability and the member which has passed through the compounding step can be easily plasticized into a tape or the like.

The method of the present invention will be further described hereinafter.

First coating step: At this step, a silver sheath member having a raw material of superconducting material coated with a first silver-containing metal is prepared. As the superconducting material, a superconducting material of oxide is preferred, and representative examples thereof include yttrium-based oxide superconducting materials and bismuth-based oxide superconducting materials. In particular, Bi(Pb)-Sr-Ca-Cu-O-based oxide superconducting materials, particularly Bi2223-based superconducting materials, have a high critical temperature and can be preferably used as superconducting wire material. As such a raw material of superconducting material there is normally used a material which can be heat-treated at the subsequent sintering step to obtain a superconducting phase. As a raw material of Bi2223-based oxide superconducting material for example, there can be exemplified a powder mainly composed of Bi2212 phase.

Such a raw material of superconducting material is coated with a first silver-containing metal to form a silver sheath member. The first silver- containing metal may be any material containing silver, not to mention pure silver, and various silver alloys mainly composed of silver can be preferably used. Specific examples of silver alloy include Ag-Mn alloy, Ag-Mg alloy, Ag-Au alloy, Ag-Sb alloy, Ag-Pd alloy, etc. The silver sheath member can be normally obtained by filling a pipe made of a silver-containing alloy with a raw material of superconducting material, and then stretching this pipe. The first silver-containing metal is thought to be used also as a sheet besides pipe.

Non-silver coating step: At this step, a non- silver coated member having the silver sheath member coated with a non-silver metal is obtained. The non- silver metal is a metal free of silver. Further, as this non-silver metal there is used a material which can form an intermetallic compound with silver wherein the oxide of the compound is a high resistivity material. In some detail, there can be exemplified at least one selected from the group including Mg, Al, Mn, Bi and Cu or an alloy mainly composed of them. In particular, Mg or Mg alloy can be preferably used. As Mg alloy, AZ-based alloy, particularly AZ31, according to ASTM is preferred. The non-silver-coated member can be normally obtained by inserting a silver sheath member into a pipe made of a non-silver metal, and then stretching this pipe. The non-silver metal is thought to be used also as a sheet besides pipe.

Compounding step: At this step, at least a part of the first silver-containing metal in the non- silver-coated member and the non-silver metal are intermetallically compounded with each other. For example, if the first silver-containing metal is silver and the non-silver metal is Mg, an Ag-Mg intermetallic compound is produced at this compounding step. In order to effect this intermetallic compounding, the non-silver -coated member may be subjected to heat treatment in a non-oxidizing atmosphere. As the non-oxidizing atmosphere there can be exemplified vacuum or inactive gas atmosphere. The degree of vacuum in the case where vacuum is used is preferably 100 Pa or less. As the inactive gas there is preferably used a gas having a low reactivity with non-silver metal such as Ar, He and Ne. The heat treatment temperature is preferably from 400°C to 700°C for example. When the heat treatment temperature is 400°C or less, intermetallic compounding can be difficultly effected, and when the heat treatment temperature is more than 700°C, the diffusion of both the metals proceeds further, making it easy to form a primary Ag solid solution. The retention time in the heat treatment maybe properly determined depending on the material and thickness of the non-silver metal. There is a tendency that the more the thickness of the non- silver metal is and the lower the heat treatment temperature is, the longer is the retention time.

Oxidizing step: At this step, the metal intermetallically compounded at the compounding step is oxidized to produce an oxide and the oxide layer is a high resistivity layer. In order to effect this oxidation, the member which has passed through the compounding step may be heat-treated in an oxidizing atmosphere. This heat treatment temperature is preferably from about 400°C to 700°C. When the heat treatment temperature is 400°C or less, sufficient oxidation of alloy can be difficultly effected, and when the heat treatment temperature is more than 700°C, the oxide cannot be lamellar and can be easily dispersed in particulate form. The oxidizing atmosphere is obtained by adjusting the oxygen partial pressure in the atmosphere. For example, the oxygen partial pressure is preferably predetermined to be from about 0.1 to 20 atm (about 10 kPa to 2 MPa). Further, though depending on the material and thickness of the alloy to be oxidized, the retention time in this heat treatment is preferably from about 1 to 20 hours.

The thickness of the high resistivity layer obtained at this oxidizing step is preferably from not smaller than 0.1 µm to not greater than 50 µm. This is because when the thickness of the high resistivity layer is less than 0.1 µm, the effect of assuring the insulation of superconducting filaments to each other to reduce AC loss is insufficient and when the thickness of the high resistivity layer is more than 50 µm, it is made difficult to diffuse and supply oxygen sufficiently into the raw material of superconducting material. More preferably, the thickness of the high resistivity layer is from not smaller than 0.1 µm to not greater than 5 µm.

Further, the material constituting the high resistivity layer is preferably in solid phase at the heat treatment temperature at the sintering step described later. At this sintering step, heat treatment for rearranging the rawmaterial into superconducting material is effected. When the material constituting the high resistivity layer, i.e., oxide stays in solid phase and shows no phase change at the heat treatment temperature during this procedure, a problem can be avoided that the material constituting the high resistivity layer becomes a liquid phase that then penetrates the raw material of superconducting material, disabling proper sintering. For example, since Bi2223 phase is produced at about 800°C at the sintering step, the high resistivity layer may be formed by a material which doesn't produce a liquid phase at a temperature of 800°C or more. In some detail, it is an oxide of alloy of the aforementioned first silver-containing metal with non-silver metal.

Sintering step: At this step, the member having a high resistivity layer formed thereon is heat- treated to convert the aforementioned raw material to a superconducting material. This heat treatment, if Bi2223 phase is formed, e.g., by Bi2212 phase, may be effected at a total pressure of from 0.1 to 50 MPa, an oxygen partial pressure of from 4 to 21 kPa and 800 to 850°C in an atmosphere of inactive gas and oxygen for 20 to 100 hours.

Second coating step: This step is a step of further coating the member which has passed through the non-silver coating step with a second silver-containing metal and may be effected as necessary. In the case where the second coating step is effected, the first silver- containing metal, non-silver metal and second silver- containing metal in the member which has passed through the second coating step are intermetallically compounded with each other at the compounding step. When the second coating step is effected, the silver-containing metal is distributed on both the inner side and outer side of the non-silver metal. The non-silver metal can under insufficient diffusion of oxygen, and by interposing this non-silver metal by a silver-containing metal excellent in oxygen diffusibility, the diffusion and supply of oxygen into the raw material at the sintering step can be sufficiently effected. In particular, in the case where a superconducting wire material having a multifilament structure is prepared, the contact of high resistivity layers surrounding each of these filaments can be avoided and the silver-containing metal can be interposed between these high resistivity layers. The second silver-containing metal is thought to be used also as a sheet besides pipe.

Third coating step: This step is a step of collectively coating a plurality of the member which have passed through the non-silver coating step with a third silver-containing metal and may be effected as necessary. By effecting the third coating step, a multifilament superconducting wire material having a plurality of superconducting materials can be obtained. For example, a multi-core wire can be obtained by putting a plurality of non-silver-coated members into a pipe of a silver-containing metal, and then stretching this pipe. The third silver-containing metal is thought to be used also as a sheet besides pipe.

Plasticizing step: This step is a step of flattening the sectional shape of the object to be worked to obtain a tape-like superconducting wire material. Typically, rolling or press working is employed. This plasticizing step is preferably effected after effecting the compounding step. In the case where the member which has passed through the compounding step is subjected to plasticizing step, the member can be easily subjected to heavy deformation if it has passed through the intermetallic compounding step even when the non-silver metal itself is a difficultly-workable material because the non-silver is intermetallically compounded with the first silver-containing metal. On the contrary, the plasticizing step may be effected before the compounding step. In this case, it is desirable that the percent reduction per pass be lowered or a material excellent in workability be selected as the non-silver metal.

Further, the superconducting wire material of the present invention is characterized in that it is obtained by the aforementioned method of the present invention. The superconducting wire material obtained by the method of the present invention has a homogeneous high resistivity layer that assures the insulation between the superconducting filaments, making it possible to realize the reduction of AC loss.

Further, the superconducting device of the present invention is characterized by the use of this superconducting wire material. The use of the superconducting wire material obtained by the method of the present invention makes it possible to realize a superconducting device having little AC loss. Specific examples of the superconducting device include superconducting cable, superconducting magnet, superconducting electricity generator, etc.

### ADVANTAGE OF THE INVENTION

(1) In accordance with the method of the present invention, a silver sheath member is coated with a non-silver metal. The silver in this silver sheath and the non-silver metal are intermetallically compounded with each other. After this intermetallic compounding, an oxidizing step is effected, making it assured that the intermetallically compounded metal can be converted to an oxide and making it possible to form a homogeneous high resistivity layer. Accordingly, the conduction between the filaments can be suppressed, making it possible to reduce AC loss.

(2) In accordance with the method of the present invention, even when the non-silver metal is a difficultly-workable material having a poor ductility or malleability, the non-silver metal can be intermetallically compounded with a silver-containing metal rich in ductility or the like to improve its workability, making it easy to plasticize the member which has passed through the compounding step into a tape form or the like.

(3) In accordance with the superconducting wire material and superconducting device of the present invention, the conduction between the filaments in the superconducting wire material can be suppressed more certainly, making it possible to reduce AC loss.

### BEST MODE FOR CARRYING OUT THE INVENTION

Embodiments of implementation of the present invention will be described hereinafter.

A superconducting wire material of the present invention is prepared in the following procedure.
(1) A raw material prepared comprising Bi, Pb, Sr, Ca and Cu at a ratio of 1.8 : 0.3 : 2.0 : 2.1 : 3.0 is packed into a first silver pipe (first silver-containing metal) having an outer diameter of 26 mm and an inner diameter of 22 mm. This pipe filled with a raw material powder is stretched in such a manner that the outer diameter thereof reaches 19 mm. At this point of time, a silver sheath member is formed.

(2) This stretched wire material is put into an Mg pipe (non-silver metal) having an outer diameter of 22 mm and an inner diameter of 20 mm, a second silver piper (second silver-containing metal) having an outer diameter of 25 mm and an inner diameter of 23 mm is fitted on the outer side of this Mg pipe, and these pipe materials are then stretched until the outer diameter thereof reaches 4.4 mm. The stretched wire material thus obtained is cut into 19 pieces. The Mg pipe is made of pure magnesium.

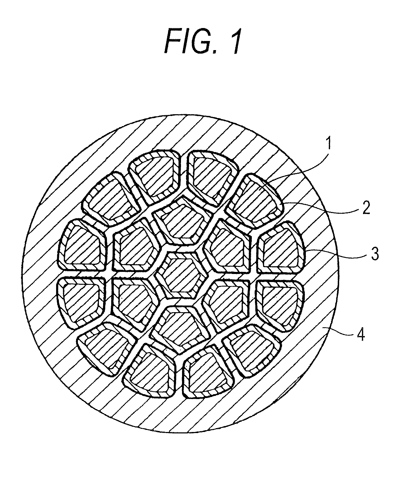

(3) These 19 wires are bundled, inserted into a third silver pipe having an outer diameter of 26 mm and an inner diameter of 22 mm (third silver-containing metal), and then stretched as it is until the outer diameter thereof reaches 1.5 mm. At this point of time, a multi-core wire is obtained. A transverse cross section of the multi-core wire is shown in a diagrammatic view of Fig. 1. The outer side of the 19 pieces of superconducting material raw material powder 1 are each surrounded by silver 2 the outer side of which is surrounded by Mg 3. Further, these Mg 3 pieces are disposed apart from each other and are collectively surrounded by silver 4.

(4) Subsequently, this multi-core wire is subjected to heat treatment at 400 to 700°C in vacuo for 5Pa so that Ag in the first silver pipe and second silver pipe and Mg in Mg pipe are intermetallically compounded with each other. Ag-Mg intermetallic compound has a higher melting point than Mg and is stable at high temperatures. This Ag-Mg intermetallic compound includes Ag-Mg₃ intermetallic compound, not to mention Ag-Mg intermetallic compound.

(5) This wire material which has passed through the compounding step is worked by a pressure roll into a tape form 0.34mm thick. Since Ag-Mg intermetallic compound has a cubic (bcc) crystalline structure, it is excellent in workability as opposed to Mg, which has a hexagonal close- packed structure (hcp).

(6) Subsequently, the tape-like wire material is heat-treated in an oxidizing atmosphere so that the Ag-Mg intermetallic compound is oxidized to form a high resistivity layer. The heat treatment conditions at this oxidizing step are oxygen partial pressure of 10 atm (about 1 MPa) and temperature of from 400 to 700°C.

(7) Subsequently, the wire material which has passed through the oxidizing step is subjected to a sintering step at which it is further subjected to heat treatment so that Bi2223 phase is produced. The heat treatment conditions at the sintering step are 815°C, 30 hours and 8 at-%, and oxygen atmosphere.

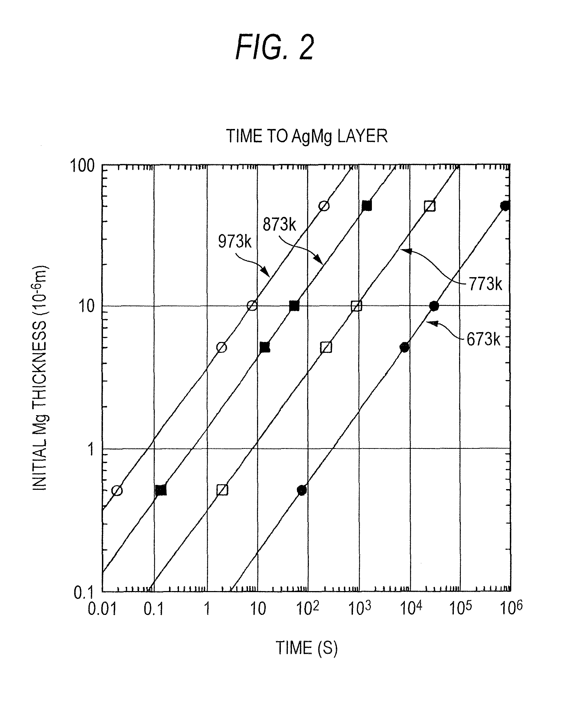

The relationship between the thickness of Mg in the initial stage (before the oxidizing step) and the temperature and time required for the intermetallic compounding of Mg having this thickness with Ag during the preparation of a tape-like superconducting wire material at the aforementioned steps is examined. The results are shown in the graph of Fig. 2. As can be seen in this graph, the higher the heat treatment temperature at the compounding step is or the smaller the initial thickness of Mg is, the shorter is the period of time in which intermetallic compounding can be attained. Accordingly, the heat treatment temperature or time at the compounding step may be predetermined according to the thickness of Mg during the intermetallic compounding on the basis of this graph.

Further, a section of the tape-like superconducting wire material thus obtained is photographed under SEM (scanning electron microscope), the thickness of the high resistivity layer is measured from this photograph, and as a result, it is from 15 to 20 µm. Further, it is confirmed that a high resistivity layer mainly composed of an oxide is formed outside the superconducting filaments.

Further, the critical current of the superconducting wire material thus obtained is measured at a temperature of 77K in the absence of external magnetic field by a 4-terminal method, and as a result, it is 20A.

### BRIEF DESCRIPTION OF THE DRAWINGS

[Fig. 1]
   Fig. 1 is a diagrammatic sectional view of a multi-core wire at the procedure of producing the superconducting wire material of the present invention.
[Fig. 2]
   Fig. 2 is a graph illustrating the relationship between the initial thickness of Mg and the temperature and time required for intermetallic compounding of Mg having this thickness with Ag.

### DESCRIPTION OF REFERENCE NUMERALS AND SIGNS

- 1: Raw superconducting material powder
- 2: Silver
- 3: Mg
- 4: Silver

## Claims

1. A method for producing a superconducting wire material, comprising:
a first coating step of coating a raw material of superconducting wire material with a first silver-containing metal to obtain a silver sheath member;
a non-silver coating step of coating the silver sheath member with a non-silver metal free of silver;
a compounding step of intermetallically compounding at least a part of the first silver-containing metal in the member which has passed through the non-silver coating step with the non-silver metal;
an oxidizing step of oxidizing the intermetallically compounded metal to for a high resistivity layer; and
a sintering step of heat-treating the member having a high resistivity layer formed thereon to convert the aforementioned raw material to a superconducting material.

2. The method for producing a superconducting wire material described in Claim 1, further comprising:
a second coating step of coating the member which has passed through the non-silver coating step with a second silver-containing metal and the first silver-containing metal, wherein
non-silver metal and second silver-containing metal in the member which has passed through the second coating step are intermetallically compounded with each other at the second coating step.

3. The method for producing a superconducting wire material described in Claim 1, wherein
the thickness of the aforementioned high resistivity layer is from not smaller than 0.1 µm to not greater than 50 µm.

4. The method for producing a superconducting wire material described in Claim 1, further comprising:
a third coating step of coating a plurality of members which have passed through the non-silver coating step with a third silver-containing metal.

5. The method for producing a superconducting wire material described in Claim 1, wherein
the material constituting the high resistivity layer is in solid phase at the heating temperature of the sintering step.

6. The method for producing a superconducting wire material described in Claim 1, wherein
the superconducting material is a superconducting material of Bi(Pb)-Sr-Ca-Cu-O-based oxide.

7. The method for producing a superconducting wire material described in Claim 1, further comprising:
a plasticizing step of plasticizing the member which has passed through the compounding step.

8. The method for producing a superconducting wire material described in Claim 1, further comprising:
a plasticizing step of plasticizing the member which has passed through the non-silver coating step.

9. A superconducting wire material obtained by the method for producing a superconducting wire material described in Claim 1.

10. A superconducting device comprising a superconducting wire material described in Claim 9.
